**Europäisches Patentamt**

**European Patent Office**

**Office européen des brevets**

(19)

(11) Veröffentlichungsnummer: **0 090 318**
**B1**

(12) # EUROPÄISCHE PATENTSCHRIFT

(45) Veröffentlichungstag der Patentschrift:
**14.06.89**

(51) Int. Cl.⁴: **H 01 L 21/28, H 01 L 21/285**

(21) Anmeldenummer: **83102803.0**

(22) Anmeldetag: **21.03.83**

(54) Verfahren zum Herstellen von integrierten MOS-Feldeffekttransistorschaltungen in Siliziumgate-Technologie mit Silizid beschichteten Diffusionsgebieten als niederohmige Leiterbahnen.

(30) Priorität: **30.03.82 DE 3211761**

(43) Veröffentlichungstag der Anmeldung:
**05.10.83 Patentblatt 83/40**

(45) Bekanntmachung des Hinweises auf die Patenterteilung:
**14.06.89 Patentblatt 89/24**

(84) Benannte Vertragsstaaten:
**AT BE FR GB IT NL SE**

(56) Entgegenhaltungen:
**EP-A- 0 000 317**
**GB-A- 2 062 959**
**US-A- 4 141 022**
**US-A- 4 283 439**

**IEEE TRANSACTIONS ON ELECTRON DEVICES, Band
ED-27, Nr. 8, Seiten 1409-1417, IEEE, New York, US; S.P.
MURARKA et al.: "Refractory silicides of titanium and
tantalum for low-resistivity gates and interconnects"
IBM TECHNICAL DISCLOSURE BULLETIN, Band 22, Nr.
8B, Januar 1980, Seiten 3861-3863, New York, US; V.L.
RIDEOUT: "Fabrication method for high performance
MESFET"**

(73) Patentinhaber: **Siemens Aktiengesellschaft Berlin und
München, Wittelsbacherplatz 2, D-8000 München 2 (DE)**

(72) Erfinder: **Schwabe, Ulrich. Dr. phil., Grünwalder
Strasse 40, D-8000 München 90 (DE)**
Erfinder: **Neppl, Franz, Dr.rer.nat., St.-Quirin-Platz 6,
D-8000 München 90 (DE)**
Erfinder: **Hieber, Konrad, Dr., Aiblinger Strasse 3,
D-8000 München 19 (DE)**

## Beschreibung

Verfahren zum Herstellen von integrierten MOS-Feldeffekttransistorschaltungen in Siliziumgate-Technologie mit Silizid beschichteten Diffusionsgebieten als niederohmige Leiterbahnen.

Die Erfindung betrifft ein Verfahren zum Herstellen von integrierten MOS-Feldeffekttransistorschaltungen in Siliziumgate-Technologie, bei dem die diffundierten Gebiete durch eine aus Tantalsilizid bestehende Schicht niederohmig gemacht werden und damit als Leiterbahnen verwendbar werden, wobei das Tantalsilizid nach Fertigstellung der Polysiliziumebene und der Erzeugung der als Source/Drain-Zonen dienenden Bereiche der Schaltung durch direktes Abscheiden auf dem mit den MOS-Strukturen versehenen Halbleitersubstrat erzeugt wird.

Eine Verringerung der Strukturgrößen von integrierten MOS-Schaltungen erfordert auch eine Verminderung der Tiefe von Diffusionsgebieten. Dadurch bedingt erhöht sich der Schichtwiderstand erheblich. Dies führt zu unerwünscht hohen Verzögerungszeiten bei $n^+$-Silizium-Leitungen und zu hohen Source/Drain-Serienwiderständen, die die Funktion von Kurzkanaltransistoren beeinträchtigen.

Diese Schwierigkeiten können umgangen werden durch eine selbstjustierende Silizidierung von Diffusionsgebieten. Es ergibt sich im gleichen Verfahrensschritt die Möglichkeit auch die Polysiliziumgates mit Silizid zu versehen (Polyzid-Gate). Aus einem Aufsatz von T. Shibata et. al. aus den Proceedings of IEMD 81, paper no. 28.2, Seite 647 bis 650 ist bekannt, dafür Platinsilizid zu verwenden, welches durch Reaktion von aufgedampften Platin und Siliziumsubstrat erzeugt wird. Die Nachteile dieses Verfahrens sind:

a) ein Verbrauch von Silizium bei der Silizidierung, wodurch Kurzschlußgefahr zum Substrat bei flachen Diffusionsgebieten besteht,

b) die Temperaturbeständigkeit wird nur für Temperaturen kleiner 800 °C gewährleistet,

c) es ist ein aufwendiges Metallisierungssystem mit Diffusionsbarriere erforderlich; durch die Vielfachschicht treten Ätzprobleme auf,

d) der Prozeß ist nicht kompatibel mit flußsäurehaltigen Chemikalien.

Die Kurzschlußgefahr kann durch Abscheidung von Platin/Silizium- oder Platin/Wolfram-Gemischen umgangen werden. Dadurch wird – bei Platin/Wolfram allerdings nur bei den niedrigen Temperaturen – der Verbrauch von Substrat-Silizium reduziert. Es geht jedoch die Selbstjustierung verloren und es werden Fotolithographieschritte notwendig.

Als selbstjustierende Alternative wurde auch eine selektive Wolfram-Abscheidung (siehe P. A. Gargini, J. Beinglass, Proceedings of IEDM 81, paper no. 3.2, Seite 54) vorgeschlagen. Folgeprozesse sind aber auf kleiner 500 °C beschränkt, da sonst Wolframsilizidbildung mit Siliziumverbrauch im Kontakt eintritt. Dies hat bei flachen Diffusionsgebieten wieder die Möglichkeit von Substratkurzschlüssen zur Folge.

Aus US-A-3 381 182 ist ein Verfahren bekannt, in dem auf eine Oberfläche, die Siliziumbereiche und Siliziumoxidbereiche enthält, ganzflächig ein Metall, zum Beispiel Molybdän, aus der Gasphase, zum Beispiel aus $MoCl_5$, durch Wasserstoffreduktion abgeschieden wird. Beim Abscheiden oder einem anschließenden Temperschritt wird die Temperatur so gewählt, daß sich auf dem Silizium eine Metallsilizidschicht bildet. Auf den Siliziumoxidbereichen bildet sich eine Metallschicht, die durch anschließendes selektives Ätzen entfernt wird.

Die Erfindung löst die gestellte Aufgabe der Verwendung von Metallsiliziden zur Reduzierung des Schichtwiderstandes der Diffusionsgebiete bei VLSI (very large scale integration)-Prozessen mit sehr flachen Diffusionsgebieten im Substrat auf eine andere Weise und ist dadurch gekennzeichnet, daß die Tantalsilizidschichtstruktur vor dem Erzeugen des Isolationsoxids zwischen der äußeren Kontaktleiterbahnebene und der Tantalsilizidebene durch selektive Abscheidung aus der Gasphase auf den aus Silizium bestehenden polykristallinen und einkristallinen Bereichen unter Verwendung eines bei der thermischen Zersetzung Halogenwasserstoff abspaltenden Reaktionsgasgemisches, bestehend aus Tantalchlorid, Wasserstoff und einer halogenierten Silanverbindung, erzeugt wird.

Durch das Verfahren nach der Lehre der Erfindung, bei dem die Diffusionsgebiete im Substrat und die Polysiliziumgatebereiche selbstjustierend durch selektive Abscheidung von Tantalsilizid mit Silizid versehen werden und dadurch niederohmig gemacht werden (3 $\Omega/\square$), ist die Möglichkeit gegeben, MOS-Feldeffekttransistoren mit geringen Source/Drain-Serienwiderständen herzustellen. Außerdem entfällt durch die selektive Abscheidung des Silizids ein Fotolithographieprozeß. Bei Verwendung von Tantalsilizid ergibt sich eine gute Haftfestigkeit; das System Tantalsilizid/Silizium ist bei Temperaturen von 1000 °C stabil. Aus diesem Grunde ist das erfindungsgemäße Verfahren mit den üblichen Metallisierungsprozessen der Siliziumgate-Technologie voll kompatibel.

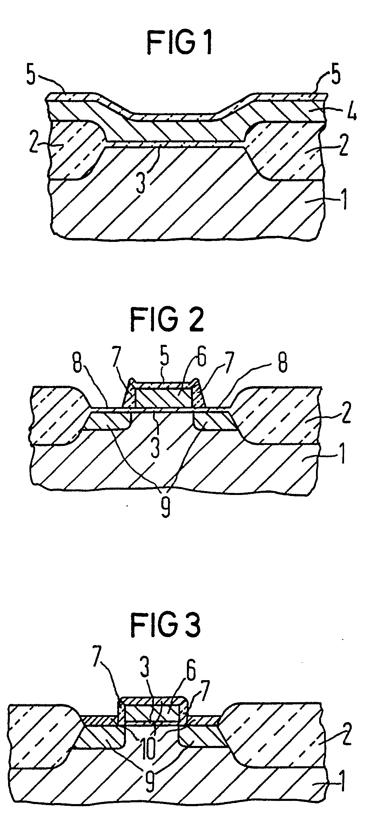

Im Folgenden werden anhand der Figuren 1 bis 6 zwei verschiedene Prozeßabläufe, welche besonders günstige Ausführungsbeispiele nach der Lehre der Erfindung darstellen, näher beschrieben. Dabei sind in den Figuren im Schnittbild nur die erfindungswesentlichen Verfahrensschritte dargestellt; gleiche Teile sind mit gleichen Bezugszeichen versehen.

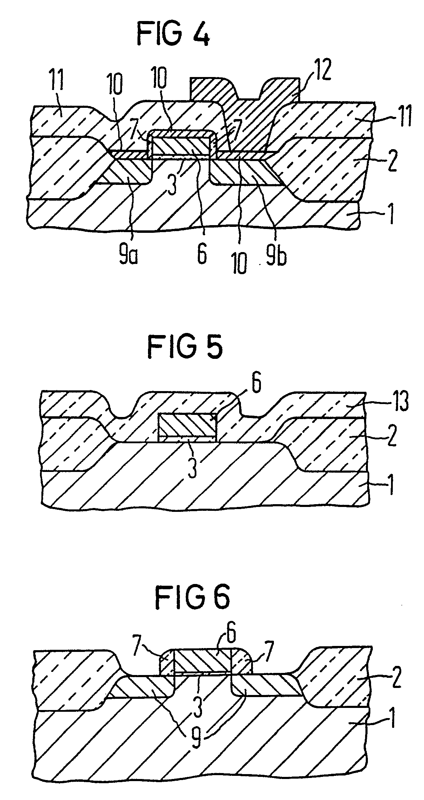

Die Figuren 1 bis 4 betreffen den Herstellungsgang eines MOS-Feldeffekttransistors, bei dem zur Verhinderung der Oxidation auf der Polysiliziumoberfläche eine Nitridschicht verwendet worden ist, während die Figuren 5 und 6 eine von den Figuren 1 und 2 abweichende Prozeßfolge darstellen, wobei nach der Strukturierung der Polysiliziumgateelektrode eine CVD-Oxid-Abscheidung und ein anisotroper Ätzprozeß durchgeführt worden ist.

Figur 1: Auf einer einkristallinen, p-dotierten (100)-orientierten Siliziumsubstratscheibe 1 mit einem spezifischen Widerstand im Bereich von 2 bis 50 $\Omega \cdot$ cm werden mit Hilfe der bekannten LOCOS-Technik (Nitridbeschichtung, Nitridstrukturierung) nach erfolgter Feldimplantation Feldoxidbereiche 2 ($d_{ox}$ = 700 nm) und aktive Bereiche definiert. Nach Entfernung der Nitridmaske wird durch Aufoxidation in den aktiven Bereichen das Gateoxid 3 in einer Schichtdicke von 40 nm erzeugt. Darauf wird durch einen CVD-Prozeß (chemical vapor deposition) ganzflächig eine 500 nm dicke Polysiliziumschicht 4 abgeschieden und mit Phosphor $n^+$ dotiert. Auf die Polysiliziumschicht 4 wird anschließend ganzflächig eine Siliziumnitridschicht 5 in einer Schichtdicke von z. B. 100 nm abgeschieden.

Figur 2: Die Siliziumnitridschicht 5 wird mit der darunterliegenden Polysiliziumschicht 4 entsprechend der Polysiliziumgateelektrode 6 strukturiert und anschließend die bei der Strukturierung freien einkristallinen Substratoberflächen 1 und die Polysiliziumflanken 7 durch thermische Oxidation erneut mit einer Oxidschicht versehen, wobei sich an den Flanken 7 des hochdotierten Polysiliziumbereiches 6 eine Schichtdicke von 200 nm, auf den übrigen einkristallinen Bereichen 8 des Substrats 1 von 60 nm einstellt. Es folgt nun eine Arsen-Ionenimplantation zur Erzeugung der $n^+$-dotierten Source/Drain-Bereiche 9.

Figur 3: Die als Maske dienende Nitridschicht 5 wird nun entfernt und eine ganzflächige Oxidätzung durchgeführt, wobei die Oxidschicht von den einkristallinen Bereichen 8 ganz abgetragen wird. Dann erfolgt der erfindungswesentliche Schritt der selektiven Abscheidung von Tantalsilizid 10 auf den aus Silizium bestehenden polykristallinen und einkristallinen Oberflächenbereichen 6 und 9. Bei dieser Abscheidung wird Tantalsilizid aus der Gasphase aus einem, Chlorwasserstoff abspaltenden Reaktionsgasgemisch abgeschieden, wobei der Druck, die Abscheidetemperatur und die Zusammensetzung des Reaktionsgases auf Werte eingestellt werden, bei denen durch die Anwesenheit des Halogenwasserstoffs bei der thermischen Zersetzung mit Ausnahme der aus Silizium bestehenden polykristallinen und einkristallinen Oberflächenbereiche 6, 9 eine Keimbildung in den anderen Bereichen 2, 7 unterdrückt wird. Das Mischungsverhältnis des aus Tantalchlorid, Wasserstoff und einer halogenierten Silanverbindung, beispielsweise Dichlorsilan ($SiH_2Cl_2$) bestehenden Gasgemisches wird auf 1 : 10 : 2, der Druck auf 133 Pa und die Substrattemperatur 1 auf 850 °C eingestellt. Die Aufwachsrate der Tantalsilizidschicht 10 beträgt 100 nm/min, die Schichtdicke 300 nm, der spezifische elektrische Widerstand 1,5 bis 3 $\Omega/\square$ (Flächeneinheit).

Figur 4: Im Anschluß an die selektive Silizidabscheidung 10 erfolgt die Abscheidung des Zwischenoxids 11, welches als Isolationsoxid zwischen der Tantalsilizidebene 10 und der Metallisierungsebene 12 dient. Dies kann beispielsweise durch eine CVD-Abscheidung in einer Schichtdicke von 1000 nm erfolgen. Es wird nun der Kontakt für den mit Tantalsilizid 10 belegten $n^+$-Bereich 9b geöffnet und die aus Aluminium/Silizium bestehende Leiterbahnebene 12 in bekannter Weise erzeugt.

Figur 5: In einer anderen Version des erfindungsgemäßen Verfahrens wird nach der Durchführung des LOCOS-Prozesses (Erzeugung der Feldoxidbereiche 2 auf dem Substrat 1, Definition der aktiven Bereiche) und der Durchführung der Gateoxidation 3 (wie bei Figur 1 beschrieben) durch einen CVD-Prozeß eine 500 nm dicke Polysiliziumschicht abgeschieden, mit Phosphor dotiert und als Polysiliziumgateelektrode 6 strukturiert. Nach Entfernen der Gateoxidschicht im Bereich der nicht von der Gateelektrode 6 bedeckten Substratoberfläche erfolgt dann eine ganzflächige CVD-Oxid-Abscheidung, wobei die $SiO_2$-Schicht 13 entsteht.

Figur 6: Anschließend wird das CVD-$SiO_2$ 13 einem anisotropen Ätzprozeß unterworfen, wobei die Flanken der hochdotierten Polysiliziumgateelektrode 6 mit einer Oxidschicht 7 bedeckt bleiben. Dieser Ätzprozeß kann beispielsweise durch reaktives Ionenätzen erfolgen. Die nachfolgende Arsen-Ionenimplantation im Transistorbereich zur Erzeugung der einkristallinen $n^+$-dotierten Source- und Drainzonen 9 erfolgt dann wie bei Figur 2 beschrieben.

Alle weiteren Verfahrensschritte von der selektiven Abscheidung der Tantalsilizidschicht 10 bis zum Metallisierungsprozeß sind den Figuren 3 und 4 sowie deren Beschreibung zu entnehmen.

**Patentansprüche**

1. Verfahren zum Herstellen von integrierten MOS-Feldeffekttransistorschaltungen in Siliziumgate-Technologie, bei dem die diffundierten Gebiete durch eine aus Tantalsilizid bestehende Schicht (10) niederohmig gemacht werden und damit als Leiterbahnen verwendbar werden, wobei das Tantalsilizid nach Fertigstellung der Polysiliziumebene (6) und der Erzeugung der als Source/Drain-Zonen (9) dienenden Bereiche der Schaltung durch direktes Abscheiden auf dem mit den MOS-Strukturen versehenen Halbleitersubstrat (1) erzeugt wird, dadurch gekennzeichnet, daß die Tantalsilizidschichtstruktur (10) vor dem Erzeugen des Isolationsoxids (11) durch selektive Abscheidung aus der Gasphase auf den aus Silizium bestehenden polykristallinen (6) und einkristallinen (9) Bereichen unter Verwendung eines bei der thermischen Zersetzung Halogenwasserstoff abspaltenden Reaktionsgasgemisches, bestehend aus Tantalchlorid, Wasserstoff und einer halogenierten Silanverbindung, erzeugt wird.

2. Verfahren nach Anspruch 1, dadurch gekennzeichnet, daß die Dicke der Silizidschicht (10) auf 200 bis 500 nm und der Schichtwiderstand des Tantalsilizides auf 1,5 bis 3 $\Omega/\square$ (Flächeneinheit) eingestellt wird.

3. Verfahren zum Herstellen von integrierten MOS-Feldeffekttransistorschaltungen in Siliziumgate-Technologie nach Anspruch 1 oder 2, gekennzeichnet durch den Ablauf der folgenden Verfahrensschritte:

a) Herstellen von strukturieren $SiO_2$-Schichten (2) auf einem p-dotierten Halbleitersubstrat (1) zur Trennung der aktiven Transistorbereiche nach dem sogenannten LOCOS- oder Isoplanarverfahren,

b) Erzeugen der Gateoxidschicht (3) durch Aufoxidieren der freien p-Substratoberfläche,

c) Abscheidung einer ganzflächigen Polysiliziumschicht (4), Dotierung dieser Schicht (4) mit $n^+$-dotierenden Stoffen und Strukturierung der Polysilizium-Gate-Elektrode (6),

d) Entfernung der Gateoxidschicht (3) im Bereich der nicht von der Gateelektrode (6) bedeckten Substratoberfläche (8),

e) Abscheidung einer $SiO_2$-Schicht (13) aus der Gasphase (CVD-Verfahren),

f) Anisotrope Ätzung des CVD-Oxids (13), wobei die Flanken (7) der Polysilizium-Gate-Elektrode (6) vom Oxid bedeckt bleiben,

g) Durchführung einer Arsen-Ionenimplantation im Transistorbereich zur Erzeugung der einkristallinen $n^+$-dotierten Source- und Drainzonen (9) im p-dotierten Substrat (1),

h) Abscheidung von Tantalsilizid (10) aus der Gasphase unter Verwendung eines bei der Reaktion Chlorwasserstoff abspaltenden Reaktionsgases, so daß sich das Tantalsilizid (10) nur auf den aus Silizium bestehenden polykristallinen (6) und einkristallinen (9) Bereichen niederschlägt,

i) Abscheidung der als Zwischenoxid (11) wirkenden Isolationsschicht,

j) Ätzung der Kontaktlochbereiche für die äußere Kontaktmetalleiterbahnebene (12) zu den silizidbedeckten Siliziumbereichen (9, 10) des Substrats (1) und

k) Durchführung der Metallisierung und Strukturierung der äußeren Kontaktmetalleiterbahnebene (12).

4. Verfahren zum Herstellen von integrierten MOS-Feldeffekttransistorschaltungen in Siliziumgate-Technologie nach Anspruch 1 oder 2, gekennzeichnet durch den Ablauf der folgenden Verfahrensschritte:

a) Herstellen von strukturierten $SiO_2$-Schichten (2) auf einem p-dotierten Halbleitersubstrat (1) zur Trennung der aktiven Transistorbereiche nach dem sogenannten LOCOS- oder Isoplanarverfahren,

b) Erzeugen der Gateoxidschicht (3) durch Aufoxidieren der freien p-Substratoberfläche (1),

c) Abscheidung einer ganzflächigen Polysiliziumschicht (4) und Dotierung dieser Schicht (4) mit $n^+$-dotierenden Stoffen,

d) Abscheidung einer Siliziumnitridschicht (5) und Strukturierung der aus Siliziumnitridschicht (5) und Polysiliziumschicht (4) bestehenden Doppelschicht,

e) Durchführung einer thermischen Oxidation, wobei sich auf den freien einkristallinen Bereichen (8) der Siliziumoberfläche eine Oxidschicht ausbildet und sich an den Flanken (7) der aus hochdotiertem Polysilizium bestehenden Gateelektrode (6) eine dickere Oxidschicht ausbildet als auf den einkristallinen Bereichen (8) des Substrats (1),

f) Durchführung einer Arsen-Ionenimplantation im Transistorbereich zur Erzeugung der einkristallinen $n^+$-dotierten Source- und Drainzonen (9) im p-dotierten Substrat (1),

g) Entfernen der Nitridschicht (5),

h) ganzflächiges Abätzen der Oxidschicht auf der Substratoberfläche (1) bis der einkristalline Bereich (8) des Substrats (1) freigelegt ist,

i) Abscheidung einer Tantalsilizidschicht (10) aus der Gasphase unter Verwendung eines bei der Reaktion Chlorwasserstoff abspaltenden Reaktionsgases, so daß sich das Tantal-Silizid (10) nur auf den aus Silizium bestehenden polykristallinen (6) und einkristallinen (9) Bereichen niederschlägt,

j) Abscheidung der als Zwischenoxid (11) wirkenden Isolationsschicht,

k) Ätzung der Kontaktlochbereiche für die Kontaktmetalleiterbahnebene (12) zu den silizidbedeckten Siliziumbereichen (9, 10) des Substrats (1),

l) Durchführung der Metallisierung und Strukturierung der äußeren Kontaktmetalleiterbahnebene (12).

5. Verfahren nach Anspruch 3 und 4, dadurch gekennzeichnet, daß als Substrat (1) ein (100)-orientierter, p-dotierter Siliziumkristall mit einem spezifischen Widerstand von 2 bis 50 $\Omega \cdot$ cm verwendet wird.

6. Verfahren nach Anspruch 3, dadurch gekennzeichnet, daß die Dicke des CVD-Oxids (13) bei Verfahrensschritt e) auf 100 bis 1000 nm eingestellt wird.

7. Verfahren nach Anspruch 4, dadurch gekennzeichnet, daß die Dicke der Oxidschicht (7) bei Verfahrensschritt e) auf 200 nm eingestellt wird.

8. Verfahren nach Anspruch 4, dadurch gekennzeichnet, daß die Dicke des bei Verfahrensschritt h) abzuätzenden Oxides 60 nm beträgt.

**Claims**

1. Process for manufacturing integrated circuits comprising MOS field effect transistors using silicon gate technology, in which the diffused regions are rendered low-resistance by a layer composed of tantalum silicide (10) and can consequently be used as conductor tracks, the tantalum silicide being produced, after completion of the polysilicon level (6) and the production of the regions of the circuit serving as source/drain zones (9), by direct deposition on the semiconductor substrates (1) provided with the MOS structures, characterized in that the tantalum silicide layer structure (10) is produced, before producing the isolation oxide (11), by selective deposition from the gas phase on the polycrystalline (6) and monocrystalline (9) regions composed of silicon using a reaction gas mixture which splits off hydrogen halide during the thermal decomposition and which is composed of tantalum chloride, hydrogen and a halogenated silane compound.

2. Process according to Claim 1, characterized in that the thickness of the silicide layer (10) is adjusted to 200 to 500 nm and the sheet resistance of the tantalum silicide to 1.5 to 3 $\Omega/\square$ (unit of area).

3. Process for manufacturing integrated circuits comprising MOS field effect transistors using silicon gate technology according to Claim 1 or 2, characterized by the cycle of the following process steps:

a) production of structured $SiO_2$ layers (2) on a p-doped semiconductor substrate (1) to separate the active transistor regions by the so-called LOCOS or isoplanar process,

b) production of the gate oxide layer (3) by oxidizing the free p-type substrate surface,

c) deposition of a polysilicon layer (4) over the entire surface, doping of said layer (4) with $n^+$-doping substances and structuring of the polysilicon gate electrode (6),

d) removal of the gate oxide layer (3) in the region of the substrate surface (8) not covered by the gate electrode (6),

e) deposition of an $SiO_2$ layer (13) from the gas phase (CVD process),

f) anisotropic etching of the CVD oxide (13), the edges (7) of the polysilicon gate electrode (6) remaining covered by oxide,

g) carrying out of an arsenic ion implantation in the transistor region to produce the monocrystalline $n^+$-doped source and drain zones (9) in the p-doped substrate (1),

h) deposition of tantalum silicide (10) from the gas phase using a reaction gas which splits off hydrogen chloride during the reaction so that tantalum silicide (10) deposits only on the polycrystalline (6) and monocrystalline (9) regions composed of silicon,

i) deposition of the isolation layer acting as intermediate oxide (11),

j) etching of the contact via regions for the outer contact metal conductor track level (12) to the silicide-covered silicon regions (9, 10) of the substrate (1) and

k) carrying out of the metallization and structuring of the outer contact metal conductor track level (12).

4. Process for manufacturing integrated circuits comprising MOS field effect transistors using silicon gate technology according to Claim 1 or 2, characterized by the cycle of the following process steps:

a) Production of structured $SiO_2$ layers (2) on a p-doped semiconductor substrate (1) to separate the active transistor regions by the so-called LOCOS or isoplanar process,

b) production of the gate oxide layer (3) by oxidizing the free p-substrate surface (1),

c) deposition of a polysilicon layer (4) over the entire surface and doping of said layer (4) with $n^+$-doping substances,

d) deposition of a silicon nitride layer (5) and structuring of the double layer composed of a silicon nitride layer (5) and a polysilicon layer (4),

e) carrying out of a thermal oxidation, an oxide layer forming on the free monocrystalline regions (8) of the silicon surface and a thicker oxide layer forming at the edges (7) of the gate electrode (6) composed of highly doped polysilicon than on the monocrystalline regions (8) of the substrate (1),

f) carrying out of an arsenic ion implantation in the transistor region to produce the monocrystalline $n^+$-doped source and drain zones (9) in the p-doped substrate (1),

g) removal of the nitride layer (5),

h) etching away of the oxide layer over the entire surface on the substrate surface (1) until the monocrystalline region (8) of the substrate (1) is laid bare,

i) deposition of a tantalum silicide layer (10) from the gas phase using a reaction gas which splits off hydrogen chloride during the reaction so that the tantalum silicide (10) is deposited only on the polycrystalline (6) and monocrystalline (9) regions composed of silicon,

j) deposition of the isolation layer acting as intermediate oxide (11),

k) etching of the contact via regions for the contact metal conductor track level (12) to the silicon-covered silicon regions (9, 10) of the substrate (1),

l) carrying out of the metallization and structuring of the outer contact metal conductor track level (12).

5. Process according to Claim 3 and 4, characterized in that a (100)-oriented, p-doped silicon crystal with a specific resistance of 2 to 50 $\Omega \cdot$ cm is used as substrate (1).

6. Process according to Claim 3, characterized in that the thickness of the CVD oxide (13) is adjusted to 100 to 1000 nm in process step e).

7. Process according to Claim 4, characterized in that the thickness of the oxide layer (7) is adjusted to 200 nm in process step e).

8. Process according to Claim 4, characterized in that the thickness of the oxide to be etched away in process step h) is 60 nm.

**Revendications**

1. Procédé de fabrication de circuits intégrés à transistors à effet de champ MOS en technologie de grille en silicium, selon lequel on confère une faible résistance ohmique aux régions diffusées par une couche (10) en siliciure de tantale, de sorte qu'elles deviennent utilisables comme conducteurs, selon lequel, après achèvement du plan de polysilicium (6) et formation des régions du circuit servant de zones (9) de source et de drain, on forme le siliciure de tantale par dépôt direct sur le substrat semi-conducteur (1) pourvu des structures MOS, caractérisé en ce que l'on crée la structure de couche en siliciure de tantale (10), avant la formation de l'oxyde d'isolement (11), par dépôt sélectif, à partir de la phase gazeuse, sur les régions en silicium polycristallin (6) et sur les régions en silicium monocristallin (9), en utilisant un mélange gazeux réactionnel, constitué de chlorure de tantale, d'hydrogène et d'un composé de silane halogéné, qui produit une déhydrohalogénation lors de la décomposition thermique.

2. Procédé selon la revendication 1, caractérisé en ce que l'on ajuste l'épaisseur de la couche de siliciure (10) à 200 à 500 nm et la résistance par unité de surface du siliciure de tantale à 1,5 à 3 $\Omega/\square$ (unité de surface).

3. Procédé de fabrication de circuits intégrés à transistors à effet de champ MOS en technologie de grille en silicium, selon la revendication 1 ou 2, caractérisé par la succession des opérations suivantes:

a) réalisation de couches (2) structurées en SiO$^2$ sur un substrat semi-conducteur (1) dopé p en vue de la séparation des régions de transistors actives, selon le procédé dit LOCOS ou Isoplanar,

b) création de la couche d'oxyde de grille (3) par oxydation de la surface de substrat p libre,

c) dépôt sur toute la surface d'une couche de polysilicium (4), dopage de cette couche (4) par des substances de dopage $n^+$ et structuration de l'électrode de grille en polysilicium (6),

d) élimination de la couche d'oxyde de grille (3) dans la région de la surface du substrat (8) non recouverte par l'électrode de grille (6),

e) dépôt d'une couche (13) en SiO$_2$ à partir de la phase gazeuse (procédé CVD),

f) gravure anisotrope de l'oxyde CVD 13, au cours de laquelle les flancs (7) de l'électrode de grille en polysilicium (6) restent couverts d'oxyde,

g) exécution d'une implantation d'ions d'arsenic dans la région de transistor pour créer des zones (9) de source et de drain monocristallines, dopées $n^+$, dans le substrat (1) dopé p,

h) dépôt de siliciure de tantale (10) à partir de la phase gazeuse en utilisant un gaz réactionnel séparant du gaz hydrochlorique lors de la réaction, de sorte que le siliciure de tantale (10) se précipite seulement sur les régions en silicium polycristallin (6) et monocristallin (9),

i) dépôt de la couche d'isolement, agissant comme oxyde intermédiaire (11),

j) gravure des régions des trous de contact menant du plan extérieur (12) des conducteurs métalliques de contact aux régions (9, 10) en silicium, couvertes de siliciure, du substrat (1) et

k) métallisation et structuration du plan extérieur (12) de conducteurs métalliques de contact.

4. Procédé de fabrication de circuits intégrés à transistors à effet de champ MOS en technologie de grille en silicium, selon la revendication 1 ou 2, caractérisé par la succession des opérations suivantes:

a) réalisation de couches (2) structurées en SiO$_2$ sur un substrat semi-conducteur (1) dopé p en vue de la séparation des régions de transistors actives, selon le procédé dit LOCOS ou Isoplanar,

b) création de la couche d'oxyde de grille (3) par oxydation de la surface de substrat p libre,

c) dépôt d'une couche (4) de polysilicium s'étendant sur toute la surface et dopage de cette couche (4) par des substances de dopage $n^+$,

d) dépôt d'une couche (5) de nitrure de silicium et structuration de la couche double constituée de la couche (5) de nitrure de silicium et de la couche (4) de polysilicium, e) exécution d'une oxydation thermique, avec formation d'une couche d'oxyde sur les régions monocristallines (8) libres de la surface de silicium et avec formation sur les flancs (7) d'une couche d'oxyde plus épaisse que sur les régions monocristallines (8) du substrat (1) de l'électrode de grille (6) en polysilicium fortement dopé,

f) exécution d'une implantation d'ions d'arsenic dans la région de transistor pour créer les zones monocristallines (9) de source et de drain, dopées $n^+$, dans le substrat (1) dopé +,

g) élimination de la couche de nitrure (5),

h) enlèvement par gravure de la couche d'oxyde sur toute la surface du substrat (1), jusqu'à ce que la région monocristalline (8) du substrat (1) soit mise à nu,

i) dépôt d'une couche de siliciure de tantale (10) à partir de la phase gazeuse en utilisant un gaz réactionnel éliminant du gaz hydrochlorique lors de la réaction, de sorte que le siliciure de tantale (10) se précipite seulement sur les régions en silicium polycristallin (6) et monocristallin (9),

j) dépôt de la couche d'isolement, agissant comme oxyde intermédiaire (11),

k) gravure des régions des trous de contact menant du plan (12) des conducteurs métalliques de contact aux régions (9, 10) en silicium, couvertes de siliciures, du substrat (1) et

l) métallisation et structuration du plan extérieur (12) de conducteurs métalliques de contact.

5. Procédé selon les revendications 3 et 4, caractérisé en ce que l'on utilise un cristal de silicium d'orientation (100), dopé p et ayant une résistance spécifique de 2 à 50 $\Omega \cdot$ cm en tant que substrat (1).

6. Procédé selon la revendication 3, caractérisé en ce que l'on ajuste l'épaisseur de l'oxyde CVD (13) dans l'opération e) à 100–1000 nm.

7. Procédé selon la revendication 4, caractérisé en ce que l'on ajuste l'épaisseur de la couche d'oxyde (7) dans l'opération e) à 200 nm.

8. Procédé selon la revendication 4, caractérisé en ce que l'épaisseur de l'oxyde à enlever par gravure dans l'opération h) est de 60 nm.

## FIG 1

## FIG 2

## FIG 3

## FIG 4

## FIG 5

## FIG 6